# EUROPÄISCHE PATENTANMELDUNG

(11) **EP 4 633 299 A1**
(43) Veröffentlichungstag der Anmeldung: **15.10.2025**
(21) Anmeldenummer: 24169924.8
(22) Anmeldetag: 12.04.2024
(51) Int. Cl.: H05K 1/14, H05K 7/14

(54) **REIHENEINBAUGERÄT UND VERFAHREN ZUR HERSTELLUNG EINES REIHENEINBAUGERÄTS**

(71) Anmelder: Theben AG, 72401 Haigerloch (DE)
(72) Erfinder: Köttig, Ludwig, 72108 Rottenburg-Dettingen (DE); Müller-Reiser, Andreas, 72358 Dormettingen (DE)
(74) Vertreter: Westphal, Mussgnug & Partner Patentanwälte mbB

(57) **Zusammenfassung**

Bereitgestellt werden ein Reiheneinbaugerät (1) mit einem Gehäuse (3) und mit einer in dem Gehäuse (3) angeordneten Leiterplatte (10), die einen Abschnitt (11) aufweist, auf dem ein Spannungsversorgungsmodul (4) und/oder ein Kommunikationsmodul realisiert ist, wobei die Leiterplatte (10) mit dem Abschnitt (11) auf dem das Spannungsversorgungsmodul (4) und/oder das Kommunikationsmodul realisiert ist, eine flexible Leiterplatte (10) ist, die einen weiteren Abschnitt (12) mit mindestens einem Steckplatz (13,14,15) zum Verfügbarmachen einer weiteren Funktion des Reiheneinbaugeräts (1) durch Einstecken eines Funktionsmoduls (5) in diesen Steckplatz (13,14,15) aufweist, und wobei der Abschnitt (12) der Leiterplatte (10), der den Steckplatz (13,14,15) trägt, relativ zu dem Abschnitt (11) der Leiterplatte (10), der das Spannungsversorgungsmodul (4) und/oder das Kommunikationsmodul trägt, abwinkelbar oder abgewinkelt ist und ein Verfahren zur Herstellung eines solchen Reiheneinbaugeräts.

## Beschreibung

Reiheneinbaugeräte sind eine weit verbreitete Bauform in der Elektroinstallationstechnik. Ihre Gehäuse haben üblicherweise einen im Wesentlichen identischen oder zumindest hochgradig ähnlichen Querschnitt, um sie blockartig nebeneinander auf einer Montageschiene, beispielsweise eine (gemäß DIN EN 50022) genormte Hutschiene, montieren zu können. Die Breite von Reiheneinbaugeräten, d.h. ihre Ausdehnung in Verlaufsrichtung der Montageschiene, wenn sie bestimmungsgemäß an dieser montiert sind, kann variieren, wobei es üblich ist, dass die Breite einem ganzzahligen Vielfachen einer halben Breite eines - umgangssprachlich auch als Sicherheitsautomat bezeichneten-Leitungsschutzschalters entspricht. Die übliche Breite eines Leitungsschutzschalters beträgt 17,5mm.

In unterschiedlichen Reiheneinbaugeräten können unterschiedliche Kombinationen von Funktionen realisiert sein. Dementsprechend ist es ein nahe liegender Gedanke, diese Funktionen als separate Module, insbesondere auf separaten Leiterplatten oder Platinen auszugestalten, die miteinander nach Bedarf kombinierbar sind, um die jeweils gewünschte Kombination von Modulen zu realisieren. Aus der EP 3 057 387 A1 und der DE 20 2006 006 615 U1 ist es bekannt, derartige Module über eine Basisleiterplatte miteinander zu verbinden, die Steckplätze zum Einstecken der in einer gegebenen Kombination vorhandenen Module aufweist, um die Versorgung der Module und den Austausch von Daten und/oder Signalen zwischen ihnen zu ermöglichen.

Nachteilig an diese Herangehensweise ist allerdings, dass mit der Basisleiterplatte eine zusätzliche Platine im Gehäuse des Reiheneinbaugeräts angeordnet werden muss. Zudem muss eine Vielzahl von Steckverbindungen realisiert werden, was die Materialkosten steigert. Noch ein weiteres Problem liegt darin, dass in vielen Fällen das feste Layout der Bahnen auf der Basisleiterplatte voraussetzt, dass bestimmte Module an vorgegebene Plätzen auf eine bestimmte Weise eingesteckt werden müssen, um ihre ordnungsgemäße Funktion zu gewährleisten. Steckt man beispielsweise ein Stromversorgungsmodul, mit dem die Stromversorgung aller Module des Reiheneinbaugeräts gewährleisten werden soll, so ein, dass die von ihm abgegebene Versorgungsspannung an einer Leiterbahn anliegt, die im Kontakt zu einer Datenschnittstelle eines anderen Moduls steht, kann dieses beschädigt oder sogar zerstört werden.

Die Aufgabe der Erfindung besteht daher darin, ein einfacher und kostengünstiger herstellbares und flexibler bestückbares Reiheneinbaugerät sowie ein Verfahren zu dessen Herstellung bereitzustellen. Diese Aufgabe wird erfindungsgemäß durch ein Reiheneinbaugerät mit den Merkmalen des Patentanspruchs 1 und ein Verfahren mit den Merkmalen des Patentanspruchs 8 gelöst. Vorteilhafte Weiterbildungen der Erfindung sind Gegenstand der abhängigen Ansprüche.

Das erfindungsgemäße Reiheneinbaugerät weist ein Gehäuse und eine in dem Gehäuse angeordnete Leiterplatte mit einem Abschnitt, auf dem ein Spannungsversorgungsmodul und/oder ein Kommunikationsmodul realisiert ist, auf.

Darüber hinaus ist erfindungsgemäß die Leiterplatte, auf der das Spannungsversorgungsmodul und/oder das Kommunikationsmodul realisiert ist, eine flexible Leiterplatte, die weiterhin einen Abschnitt mit mindestens einem Steckplatz zum Verfügbarmachen einer weiteren Funktion des Reiheneinbaugeräts durch Einstecken eines Funktionsmoduls in diesen Steckplatz aufweist.

Anders als es bei bekannten Reiheneinbaugeräten mit einer Basisleiterplatte der Fall ist, ist bei der erfindungsgemäßen Ausgestaltung mindestens eine der von allen Funktionsmodulen benötigten gemeinsamen Funktionen Stromversorgung und Kommunikation auf der Leiterplatte realisiert, die die Steckplätze für das Hinzufügen weiterer Module trägt und damit auch eine feste Belegung der Pole der Steckplätze, an denen diese Funktion anliegt, vorgegeben.

Möglichen Bauraumproblemen, die sich daraus ergeben könnten, wird dadurch vorgebeugt, dass erfindungsgemäß der Abschnitt der Leiterplatte, der den Steckplatz trägt, relativ zu dem Abschnitt der Leiterplatte, der das Spannungsversorgungsmodul und/oder das Kommunikationsmodul trägt, abwinkelbar ist oder abgewinkelt ist. Mit der Nennung der Alternative "abwinkelbar oder abgewinkelt" soll dabei zum Ausdruck gebracht werden, dass sowohl in Starrflex- als auch in Semiflex-Technik ausgeführte Leiterplatten dieses Merkmal erfüllen. Mit anderen Worten gesagt ist also der Abschnitt der Leiterplatte, der den Steckplatz trägt, mit dem Abschnitt der Leiterplatte, der das Spannungsversorgungsmodul und/oder das Kommunikationsmodul trägt, über einen Verbindungsabschnitt, der ein solches Abwinkeln mindestens einmal ermöglicht und ein Bestandteil der Leiterplatte ist, verbunden.

Durch diese Maßnahme kann ein Abschnitt der Leiterplatte, auf dem die gemeinsame Funktion Spannungsversorgung und/oder Kommunikation realisiert ist, geometrisch genauso positioniert werden, wie ein in einen Steckplatz eingestecktes Funktionsmodul. Besonders vorteilhaft ist es dabei, wenn der Abschnitt der Leiterplatte, der den Steckplatz trägt, rechtwinklig von dem Abschnitt der Leiterplatte, der das Spannungsversorgungsmodul und/oder das Kommunikationsmodul trägt, abgewinkelt ist.

Insbesondere werden dadurch Einbaugeometrien möglich, bei denen der Steckplatz zu der Wand des Gehäuses, die bei bestimmungsgemäßer Installation des Reiheneinbaugeräts an einer Montageschiene anliegt, zeigt, was üblicherweise bedeutet, dass der Abschnitt der Leiterplatte, an dem der Steckplatz angeordnet ist, parallel zu dieser Wand des Gehäuses, oder in der Nähe einer dieser Wand gegenüberliegenden Wand verläuft. Der Abschnitt der Leiterplatte, der das Spannungsversorgungsmodul und/oder das Kommunikationsmodul trägt, kann dann senkrecht zu diesen Wänden verlaufen. Selbstverständlich kann gewünschtenfalls aber auch die Orientierung der Leiterplattenabschnitte so gewählt werden, dass der Steckplatz oder die Steckplätze so ausgerichtet sind, dass die eingesteckten Funktionsmodule parallel zu der Wand des Gehäuses, die bei bestimmungsgemäßer Installation des Reiheneinbaugeräts an einer Montageschiene anliegt, verlaufen oder theoretisch auch parallel zur Ober-/Unterseite des Gehäuses, so dass die langen Schmalseiten der Funktionsmodulleiterplatten dann nach vorne und zur Montageschiene zeigen, so dass sie waagerecht im Gehäuse liegen.

Vorteilhafterweise kann bei einer Weiterbildung der Erfindung auf dem Abschnitt der Leiterplatte, der den Steckplatz trägt, mindestens eine weitere gemeinsame Funktion realisiert sein.

Insbesondere kann in der oben diskutierten Einbaugeometrie, bei der der Abschnitt der Leiterplatte, an dem der Steckplatz angeordnet ist, parallel zu und in der Nähe der Wand, die der bei bestimmungsgemäßer Installation des Reiheneinbaugeräts an einer Montageschiene anliegenden Wand gegenüberliegt, diese weitere gemeinsame Funktion eine Anzeige und/oder ein Bedienelement sein.

Da in dem Abschnitt der Leiterplatte, der den Steckplatz trägt, im Wesentlichen nur Leiterbahnen und die Steckplätze angeordnet sein müssen, kann er schmaler sein als der Abschnitt der Leiterplatte, der das Spannungsversorgungsmodul und/oder das Kommunikationsmodul trägt. Dies spart nicht nur Material, sondern kann, wenn das Gehäuse ein typisches gestuftes Hutschienengehäuse ist, bei der oben vorgeschlagenen Einbaugeometrie zu einer besonders effizienten Nutzung des verfügbaren Innenraums, der sich im an der Wand installierten Zustand des Reiheneinbaugeräts in Richtung auf den Betrachter hin verjüngt, beitragen

Besonders bevorzugt ist eine Weiterbildung der Erfindung, bei der die Leiterplatte, auf der das Spannungsversorgungsmodul und/oder das Kommunikationsmodul realisiert ist, mindestens einen zweiten abwinkelbaren oder abgewinkelten Abschnitt aufweist. Konkret kann dies zu einer U-förmigen Leiterplatte führen, bei der der Boden des U von dem Abschnitt gebildet wird, der den oder die Steckplätze trägt und die Schenkel des U von den das Spannungsversorgungsmodul bzw. das Kommunikationsmodul tragenden Abschnitten gebildet werden.

Das erfindungsgemäße Verfahren zur Herstellung eines solchen Reiheneinbaugeräts zeichnet sich dadurch aus, dass ein Gehäuse und eine Leiterplatte, auf der das Spannungsversorgungsmodul und/oder das Kommunikationsmodul realisiert ist und auf der mindestens ein Steckplatz zum Verfügbarmachen einer weiteren Funktion des Reiheneinbaugeräts durch Einstecken eines Funktionsmoduls in diesen Steckplatz vorhanden ist, wobei der Abschnitt der Leiterplatte, der den Steckplatz trägt, von dem Abschnitt der Leiterplatte, der das Spannungsversorgungsmodul und/oder das Kommunikationsmodul trägt, abwinkelbar ist oder abgewinkelt ist, bereitgestellt werden und dass diese Leiterplatte im abgewinkelten Zustand in das Gehäuse eingeführt wird.

Eine besonders einfache Bestückung mit den jeweiligen Funktionsmodulen, die in den oder die in die Steckplätze eingesteckt werden, ist möglich, wenn in mindestens einen, vorzugsweise in jeden, der Steckplätze, die auf der Leiterplatte vorhanden sind, ein Funktionsmodul eingesteckt wird, ehe die Leiterplatte in den abgewinkelten Zustand überführt wird.

Die Erfindung wird nachfolgend anhand von Figuren, die ein Ausführungsbeispiel der Erfindung zeigen, näher erläutert. Es zeigt:
- Fig.1:: Eine schematische Darstellung eines Blicks in das Innere eines auf einer Montageschiene befestigten Ausführungsbeispiels eines Reiheneinbaugeräts, und
- Fig.2:: Die bestückte Leiterplatte des Reiheneinbaugeräts aus Figur 1 vor dem Einbau in das Gehäuse des Reiheneinbaugeräts.

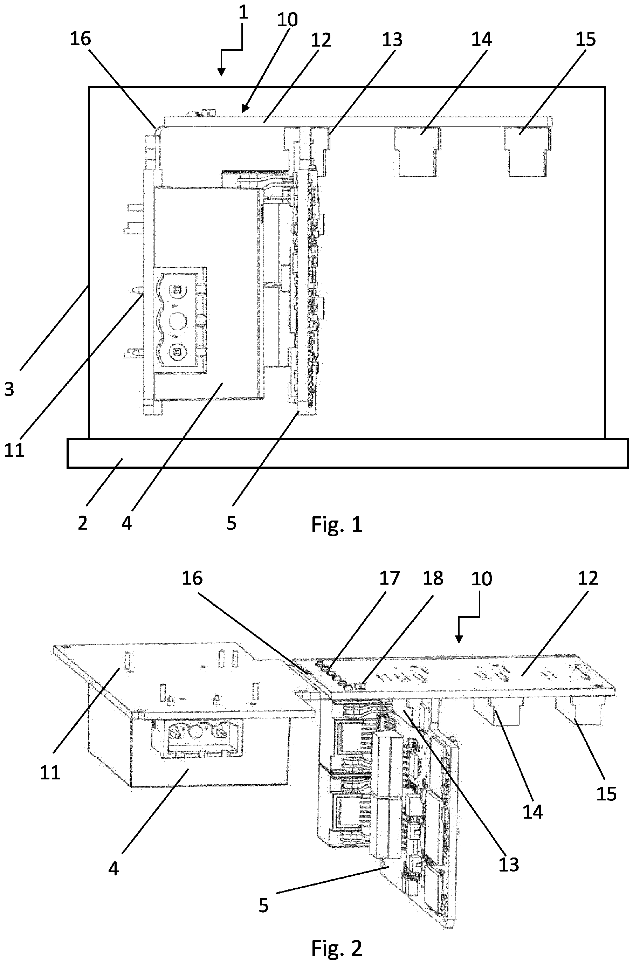

Figur 1 zeigt ein Reiheneinbaugerät 1, welches auf einer Montageschiene 2 befestigt ist in schematischer Weise. Das Reiheneinbaugerät 1 weist ein Gehäuse 3 auf, in dessen Innenraum eine Leiterplatte 10 angeordnet ist, welche einen Abschnitt 11 aufweist, auf dem eine hier als Spannungsversorgungsmodul 4 realisierte gemeinsame Funktion realisiert ist. Statt des Spannungsversorgungsmoduls 4 könnte beispielsweise auch als gemeinsame Funktion ein Kommunikationsmodul oder ein gemeinsames Spannungsversorgungs- und Kommunikationsmodul auf dem Abschnitt 11 der Leiterplatte 10 realisiert sein.

Auf der Leiterplatte 10 ist ein weiterer Abschnitt 12 vorhanden, auf dem im dargestellten Beispiel drei Steckplätze 13,14,15 zum Verfügbarmachen einer weiteren Funktion des Reiheneinbaugeräts 1 vorhanden sind. In dem in Figur 1 gezeigten Beispiel ist ein Funktionsmodul 5 in einen der Steckplätze 13,14,15 eingesteckt.

Dabei ist der Abschnitt 12 der Leiterplatte 10, der die Steckplätze 13,14,15 trägt, relativ zu dem Abschnitt 11 der Leiterplatte 10, der die als Spannungsversorgungsmodul 4 realisierte gemeinsame Funktion trägt, abwinkelbar und/oder abgewinkelt, nämlich um etwa 90 °, so dass im im Gehäuse 3 eingebauten Zustand der Abschnitt 11 der Leiterplatte 10, der die als Spannungsversorgungsmodul 4 realisierte gemeinsame Funktion trägt, im Wesentlichen senkrecht zur Montageschiene 2 verläuft und der Abschnitt 12 der Leiterplatte 10, der die Steckplätze 13,14,15 trägt, im Wesentlichen parallel zur Montageschiene 2 verläuft. In diesem Ausführungsbeispiel ist dabei eine Orientierung gewählt, in der die Steckplätze 13,14,15 zu der Wand des Gehäuses, die bei bestimmungsgemäßer Installation des Reiheneinbaugeräts an einer Montageschiene 2 anliegt, zeigen.

Diese Orientierung hat insbesondere den Vorteil, dass auf der bei ordnungsgemäß auf der Montageschiene 2 installiertem Reiheneinbaugerät 1 auf der von der Montageschiene 2 weg weisenden Seite des Abschnitts 12 der Leiterplatte 10 die Möglichkeit besteht, mindestens eine weitere gemeinsame Funktion, im dargestellten Ausführungsbeispiel eine Anzeige 17 und ein Bedienelement 18, realisiert werden kann. Zusätzlich können so auch an den Funktionsmodulen leicht die typischerweise benötigten Verbindungsklemmen angebracht werden.

Man erkennt ferner, dass der Abschnitt 12 der Leiterplatte 10, der die Steckplätze 13,14,15 trägt, schmaler ist als der Abschnitt 11 der Leiterplatte 10, der die im gezeigten Ausführungsbeispiel als Spannungsversorgungsmodul 4 realisierte gemeinsame Funktion trägt. Dadurch kann der Abschnitt 12 der Leiterplatte 10, der die Steckplätze 13,14,15 trägt, bei Reiheneinbaugeräten 1 mit sich gestuft in Richtung von der Ebene, in der bei bestimmungsgemäßer Installation des Reiheneinbaugeräts die Montageschiene liegt, weg verjüngenden Gehäusen den verfügbaren Bauraum gut ausnutzen.

Das Abwinkeln der Leiterplatte 10, das sie in den in Figur 1 gezeigten Zustand überführt, erfolgt im hier diskutierten Beispiel im Laufe des Herstellungsprozesses, indem die bestückte Leiterplatte 10 zunächst in dem in Figur 2 dargestellten gestreckten Zustand, in dem der Abschnitt 11 der Leiterplatte 10, der die als Spannungsversorgungsmodul 4 realisierte gemeinsame Funktion trägt, im Wesentlichen in derselben Ebene wie der Abschnitt 12 der Leiterplatte 10, der die Steckplätze 13,14,15 trägt, verläuft und mit diesem über einen flexiblen Verbindungsabschnitt 16 der Leiterplatte 10 verbunden ist, bereitgestellt, anschließend abgewinkelt und in das Gehäuse 3 eingesetzt wird. Vorzugsweise erfolgt auch das Bestücken der Leiterplatte 10 in diesem gestreckten Zustand. Dies bringt den Vorteil mit sich, dass die gestreckte Leiterplatte mit herkömmlichen Verfahren hergestellt, bearbeitet und bestückt werden kann.

### Bezugszeichenliste

- 1: Reiheneinbaugerät
- 2: Montageschiene
- 3: Gehäuse
- 4: Spannungsversorgungsmodul
- 5: Funktionsmodul
- 10: Leiterplatte
- 11: Abschnitt
- 12: Abschnitt
- 13: Steckplatz
- 14: Steckplatz
- 15: Steckplatz
- 16: flexibler Verbindungsabschnitt
- 17: Anzeige
- 18: Bedienelement

## Patentansprüche

1. Reiheneinbaugerät (1) mit einem Gehäuse (3) und mit einer in dem Gehäuse (3) angeordneten Leiterplatte (10), die einen Abschnitt (11) aufweist, auf dem ein Spannungsversorgungsmodul (4) und/oder ein Kommunikationsmodul realisiert ist,
**dadurch gekennzeichnet, dass** die Leiterplatte (10) mit dem Abschnitt (11) auf dem das Spannungsversorgungsmodul (4) und/oder das Kommunikationsmodul realisiert ist, eine flexible Leiterplatte (10) ist, die einen weiteren Abschnitt (12) mit mindestens einem Steckplatz (13,14,15) zum Verfügbarmachen einer weiteren Funktion des Reiheneinbaugeräts (1) durch Einstecken eines Funktionsmoduls (5) in diesen Steckplatz (13,14,15) aufweist, und
dass der Abschnitt (12) der Leiterplatte (10), der den Steckplatz (13,14,15) trägt, relativ zu dem Abschnitt (11) der Leiterplatte (10), der das Spannungsversorgungsmodul (4) und/oder das Kommunikationsmodul trägt, abwinkelbar oder abgewinkelt ist.

2. Reiheneinbaugerät (1) nach Anspruch 1,
**dadurch gekennzeichnet, dass** der Abschnitt (12) der Leiterplatte (10), der den Steckplatz (13,14,15) trägt, rechtwinklig von dem Abschnitt (11) der Leiterplatte (10), der das Spannungsversorgungsmodul (4) und/oder das Kommunikationsmodul trägt, abgewinkelt ist.

3. Reiheneinbaugerät (1) nach Anspruch 2,
**dadurch gekennzeichnet, dass** der Steckplatz (13,14,15) zu der Wand des Gehäuses (3), die bei bestimmungsgemäßer Installation des Reiheneinbaugeräts (1) an einer Montageschiene (2) anliegt, zeigt.

4. Reiheneinbaugerät (1) nach einem der Ansprüche 1 bis 3,
**dadurch gekennzeichnet, dass** auf dem Abschnitt (12) der Leiterplatte (10), der den Steckplatz (13,14,15) trägt, mindestens eine weitere gemeinsame Funktion realisiert ist.

5. Reiheneinbaugerät (1) nach Anspruch 4,
**dadurch gekennzeichnet, dass** die weitere realisierte gemeinsame Funktion eine Anzeige (17) und/oder ein Bedienelement (18) ist.

6. Reiheneinbaugerät (19 nach einem der Ansprüche 1 bis 5,
**dadurch gekennzeichnet, dass** der Abschnitt (12) der Leiterplatte (10), der den Steckplatz (13,14,14) trägt, schmaler ist als der Abschnitt (11) der Leiterplatte (10), der das Spannungsversorgungsmodul (4) und/oder das Kommunikationsmodul trägt.

7. Reiheneinbaugerät (1) nach einem der Ansprüche 1 bis 6,
**dadurch gekennzeichnet, dass** die Leiterplatte (10), auf der das Spannungsversorgungsmodul (4) und/oder das Kommunikationsmodul realisiert ist, mindestens einen zweiten abwinkelbaren oder abgewinkelten Abschnitt aufweist.

8. Verfahren zur Herstellung eines Reiheneinbaugeräts (1) nach einem der Ansprüche 1 bis 7,
**dadurch gekennzeichnet,**
**dass** ein Gehäuse (3) und eine Leiterplatte (10), auf der das Spannungsversorgungsmodul (4) und/oder das Kommunikationsmodul realisiert ist und auf der mindestens ein Steckplatz (13,14,15) zum Verfügbarmachen einer weiteren Funktion des Reiheneinbaugeräts (1) durch Einstecken eines Funktionsmoduls (5) in diesen Steckplatz (13,14,15) vorhanden ist, wobei der Abschnitt (11) der Leiterplatte (10), der den Steckplatz (13,14,15) trägt, von dem Abschnitt (11) der Leiterplatte (10), der das Spannungsversorgungsmodul (4) und/oder das Kommunikationsmodul trägt, abwinkelbar ist oder abgewinkelt ist, bereitgestellt werden, und
**dass** diese Leiterplatte (10) im abgewinkelten Zustand in das Gehäuse (3) eingeführt wird.

9. Verfahren nach Anspruch 8,
**dadurch gekennzeichnet, dass** in mindestens einen, vorzugsweise in jeden, der Steckplätze (13,14,15), die auf der Leiterplatte (10) vorhanden sind, ein Funktionsmodul (5) eingesteckt wird, ehe die Leiterplatte (10)in den abgewinkelten Zustand überführt wird.
